# EUROPÄISCHE PATENTANMELDUNG

(11) **EP 1 328 010 A2**
(43) Veröffentlichungstag der Anmeldung: **16.07.2003**
(21) Anmeldenummer: 03000269.5
(22) Anmeldetag: 08.01.2003
(51) Int. Cl.: H01L 21/00

(54) **Verfahren zur automatisierten Handhabung von Halbleiterscheiben**

(30) Priorität: 09.01.2002 DE 10200521
(71) Anmelder: Infineon Technologies AG, 81669 München (DE)
(72) Erfinder: Mariani, Franco, 93077 Bad Abbach (DE)
(74) Vertreter: Epping Hermann & Fischer

(57) **Zusammenfassung**

Bei dem Verfahren werden die Halbleiterscheiben in Verpackungen angeordnet, die vor dem Einbringen der Halbleiterscheiben mit Öffnungen oder einer reliefartigen Struktur oder Prägung versehen werden. Damit wird die Entstehung eines Unterdrucks zwischen einer jeweils entnommenen Halbleiterscheibe und einer in dem Stapel nachfolgenden Halbleiterscheibe verhindert. Vorzugsweise wird Papier als Umhüllung verwendet, in das zuvor Löcher gestanzt worden sind oder in das eine reliefartige Struktur eingeprägt wurde.

## Beschreibung

Die vorliegende Erfindung betrifft ein Verfahren zur automatisierten Aufnahme von Halbleiterscheiben aus einem Stapel.

Beim Transport von Halbleiterscheiben (Wafer) wird ein Schutzpapier oder ein Schutzkunststoff zwischen die Halbleiterscheiben gelegt, um eine gegenseitige Berührung der Scheiben zu verhindern. Dieses Schutzpapier beziehungsweise dieser Schutzkunststoff bildet eine Umhüllung der einzelnen Halbleiterscheiben. Bei einer automatisierten Handhabung werden die Halbleiterscheiben mittels einer Vakuumaufnahmevorrichtung, die einen Unterdruck erzeugt, (Vakuumpinzette) aus dieser Umhüllung entnommen. Auf Grund des entstehenden Unterdruckes kommt es vor, dass eine in dem Stapel der Halbleiterscheiben unter der zu entnehmenden Halbleiterscheibe nachfolgende Halbleiterscheibe an dem Schutzpapier oder Schutzkunststoff haften bleibt. Diese nachfolgende Halbleiterscheibe wird dann mit angehoben, aber nicht sicher festgehalten, so dass die Gefahr besteht, dass die untere Halbleiterscheibe abfällt und bricht.

Es ist außerdem technisch sehr aufwendig, das Schutzpapier beziehungsweise den Schutzkunststoff von der Halbleiterscheibe in einem automatisierten Arbeitsgang zu trennen. Damit wird der Durchsatz der Anlagen eingeschränkt, und es kommt zu Fehlfunktionen.

Aufgabe der vorliegenden Erfindung ist es, anzugeben, wie die eingangs erläuterten Probleme bei einer automatisierten Handhabung von in Umhüllungen oder Schutzverpackungen angeordneten Halbleiterscheiben beseitigt werden können.

Diese Aufgabe wird mit dem Verfahren mit den Merkmalen des Anspruches 1 gelöst. Ausgestaltungen ergeben sich aus dem abhängigen Anspruch.

Bei dem Verfahren werden die Halbleiterscheiben in Verpackungen angeordnet, die vor dem Einbringen der Halbleiterscheiben mit Öffnungen oder einer reliefartigen Struktur oder Prägung versehen werden. Damit wird die Entstehung eines Unterdrucks zwischen einer jeweils entnommenen Halbleiterscheibe und einer in dem Stapel nachfolgenden Halbleiterscheibe verhindert. Vorzugsweise wird Papier als Umhüllung verwendet, in das zuvor Löcher gestanzt worden sind oder in das eine reliefartige Struktur eingeprägt wurde.

In den beigefügten Figuren sind ein Halbleiterscheibenstapel mit zwischengelegten Schutzpapieren bzw. ein Ausschnitt aus einem erfindungsgemäß verwendeten Schutzpapier als Beispiele im Schema dargestellt.

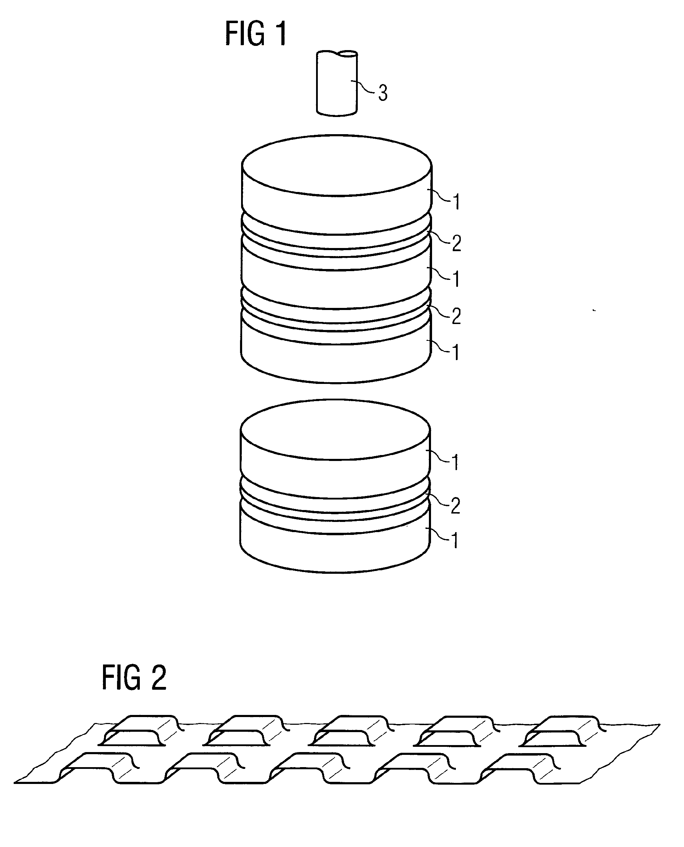

In der Figur 1 ist ein Stapel aus Halbleiterscheiben 1 (Wafer) dargestellt, deren Dicke im Vergleich zu den lateralen Abmessungen der besseren Erkennbarkeit halber stark übertrieben wiedergegeben ist. Zwischen den einzelnen Halbleiterscheiben befindet sich ein Schutzpapier als Verpackung, mit dem die Halbleiterscheiben umhüllt sind; in der Figur 1 sind aber nur dünne scheibenförmige Anteile der Umhüllung oder Verpackung 2 zwischen den einzelnen Halbleiterscheiben 1 eingezeichnet. Der oberste Wafer wird hier mit einer durch einen Ansaugstutzen 3 angedeuteten Vakuumaufnahmevorrichtung abgehoben. Um zu verhindern, dass die nachfolgende Halbleiterscheibe an dem zwischen der obersten Halbleiterscheibe und der nachfolgenden Halbleiterscheibe vorhandenen Schutzpapier anhaftet und somit abgehoben wird, wird das Schutzpapier z. B. in der in der Figur 2 dargestellten Weise mit einer reliefartigen Struktur versehen, indem z. B. eine Vielzahl von Ausbuchtungen in das Papier geprägt wird. Statt eines Schutzpapiers kann ein Schutzkunststoff verwendet werden.

Der in der Verpackung entstehende Unterdruck bei der Entnahme der Halbleiterscheibe wird dadurch reduziert, dass die Umhüllung eine Ausgestaltung aufweist, die dafür sorgt, dass beim Verpacken kleine Luftpolster zwischen den Halbleiterscheiben bestehen bleiben. Es wird so vermieden, dass ein Unterdruck zwischen den Halbleiterscheiben entsteht, der mehrere Scheiben aneinander anhaften lässt. Zu diesem Zweck wird die Verpackung in einer speziellen Form ausgebildet. Bei Verwendung einer Verpackung aus Papier oder Kunststoff können in das Papier beziehungsweise den Kunststoff kleine Löcher gestanzt werden oder eine reliefartige Struktur (Profilierung) eingeprägt werden. Die genaue Ausgestaltung der reliefartigen Struktur der Verpackung ist im Prinzip frei wählbar. Die Figur 2 zeigt nur ein mögliches Beispiel.

Bezugszeichenliste
- 1: Halbleiterscheibe
- 2: Umhüllung oder Verpackung
- 3: Ansaugstutzen der Vakuumaufnahmevorrichtung

## Patentansprüche

1. Verfahren zur automatisierten Handhabung von Halbleiterscheiben, bei dem die Halbleiterscheiben (1) mittels einer Vakuumaufnahmevorrichtung (3), die einen Unterdruck erzeugt, einzeln von einem Stapel von mindestens zwei übereinander liegenden Halbleiterscheiben aus einer Umhüllung oder Verpackung (2) entnommen werden,
**dadurch gekennzeichnet, dass**
zuvor ein für die Umhüllung oder Verpackung vorgesehenes Material mit Löchern oder einer reliefartigen Struktur oder Prägung versehen wird, um zu verhindern, dass an einer jeweils entnommenen Halbleiterscheibe eine in dem Stapel nachfolgende Halbleiterscheibe anhaftet.

2. Verfahren nach Anspruch 1, bei dem
Papier als Umhüllung oder Verpackung (2) verwendet wird und vor dem Verpacken der Halbleiterscheiben (1) in das Papier Löcher gestanzt werden oder eine reliefartige Struktur eingeprägt wird.

3. Verfahren nach Anspruch 1, bei dem
Kunststoff als Umhüllung oder Verpackung (2) verwendet wird und
vor dem Verpacken der Halbleiterscheiben (1) in dem Kunststoff Löcher hergestellt werden oder eine reliefartige Struktur ausgeformt wird.
